# EUROPEAN PATENT APPLICATION

(11) **EP 4 822 344 A1**
(43) Date of publication of application: **14.10.2026**
(21) Application number: 23960702.1
(22) Date of filing: 04.12.2023
(51) Int. Cl.: G01N 24/00

(54) **NUCLEAR MAGNETIC RESONANCE SENSING DEVICE AND NUCLEAR MAGNETIC RESONANCE SENSING METHOD**

(71) Applicant: Sumida Electric Co., Ltd., Natori City, Miyagi 981-1226 (JP); Kyoto University, Kyoto-shi, Kyoto 606-8501 (JP)
(72) Inventor: YOSHII, Yoshiharu, Natori City, Miyagi 9811226 (JP); SAKO, Akifumi, Natori City, Miyagi 9811226 (JP); MIZUOCHI, Norikazu, Kyoto-shi, Kyoto 606-8501 (JP); OHKI, Izuru, Kyoto-shi, Kyoto 606-8501 (JP)
(74) Representative: Winter, Brandl - Partnerschaft mbB
(86) International application number: PCT/JP2023/043232
(87) International publication number: WO 2025/120684

(57) **Abstract**

A nuclear magnetic resonance sensing part (1) applies a high-frequency magnetic field based on an RF signal to a target object and generates an observation signal having a frequency shifted from a frequency of the RF signal by a frequency of an NMR signal. A mixer part (6) generates an IF demodulation signal including the NMR signal based on an LO signal. On the other hand, a mixer part (8) generates a pseudo IF signal from the LO signal and the RF signal, and a phase detection part (9) detects a specific phase in a waveform of the pseudo IF signal. In a digitizing device (21), a physical field generator (41) generates a magnetic field or the like corresponding to the IF demodulation signal that has passed through a low-pass filter (7), an optical quantum sensor part (42) generates light corresponding to the magnetic field or the like by a sensing member, and an ADC (43) digitizes a sensor signal obtained from the light by photoelectric conversion. The optical quantum sensor part (42) performs the above-described quantum operation at a timing of the detected specific phase.

## Description

### TECHNICAL FIELD

The present invention relates to a nuclear magnetic resonance sensing device and a nuclear magnetic resonance sensing method.

### BACKGROUND ART

In general, a measurement device using nuclear magnetic resonance makes nuclear magnetization resonate by applying a high frequency magnetic field based on an RF (Radio Frequency) signal having a frequency close to a precession frequency with a high frequency coil with respect to a measuring object, and detects the resonated nuclear magnetization with a receiving coil and generates an observation signal including a nuclear magnetic resonance (NMR) signal.

A certain nuclear magnetic resonance sensing device (a) applies a high frequency magnetic field based on an RF signal to a target object and generates an observation signal with a frequency that is shifted from a frequency of the RF signal by a frequency of a NMR signal; (b) generates an IF demodulation signal including the NMR signal using a mixer; (c) extracts a low frequency band component of the IF demodulation signal using a low-pass filter; (d) furthermore, generates, in a digitizing device, using a physical field generator, such as a magnetic field corresponding to the IF demodulation signal that has passed through the low-pass filter; (e) generates, in an optical quantum sensor part, using a sensing member, light corresponding to such as the magnetic field, and converts the light into a sensor signal using a photoelectric element; and (f) digitizes the sensor signal using an analog/digital converter (for instance, refer to Patent Document 1). This optical quantum sensor part performs a quantum operation on the above-mentioned sensing member and causes the sensing member to generate the light corresponding to such as the magnetic field mentioned above.

### PRIOR ART DOCUMENT

### PATENT DOCUMENT

Patent Document 1: International Patent Publication Number WO 2023/089883.

### SUMMARY OF THE INVENTION

### PROBLEMS TO BE SOLVED BY THE INVENTION

In the nuclear magnetic resonance sensing device mentioned above, a sensitivity (such as an intensity of the light mentioned above) changes depending on the timing at which the above-mentioned quantum operation is performed. Therefore, it is necessary to appropriately set the timing at which the above-mentioned quantum operation is performed in order to achieve an excellent sensitivity.

The present invention has an object that is to obtain a nuclear magnetic resonance sensing device and a nuclear magnetic resonance sensing method in which a timing at which a quantum operation is performed is appropriately set and sensing is performed with an excellent sensitivity.

### MEANS FOR SOLVING THE PROBLEMS

A nuclear magnetic resonance sensing device according to the present invention includes a nuclear magnetic resonance sensing part that applies a high frequency magnetic field based on an RF signal to a target object and generates an observation signal having a frequency shifted from a frequency of the RF signal by a frequency of a nuclear magnetic resonance signal, a first mixer part that performs intermediate frequency demodulation of the observation signal based on a local oscillation signal to generate an intermediate frequency demodulation signal including the nuclear magnetic resonance signal, a low-pass filter that attenuates a component of a high frequency band side of the intermediate frequency demodulation signal, a digitizing device that digitizes the intermediate frequency demodulation signal that has passed through the low-pass filter, a second mixer part that generates a pseudo intermediate frequency signal from the local oscillation signal and the RF signal, and a phase detection part that detects a specific phase in a waveform of the pseudo intermediate frequency signal. The digitizing device includes a physical field generator that generates a magnetic field or an electric field corresponding to the intermediate frequency demodulation signal that has passed through the low-pass filter, an optical quantum sensor part that generates light corresponding to the magnetic field or the electric field using a sensing member and converts the light into an electrical signal as a sensor signal using a photoelectric element, and an analog/digital converter that digitizes the sensor signal. Further, the optical quantum sensor part causes the sensing member to generate the light corresponding to the magnetic field or the electric field by performing a quantum operation on the sensing member at a timing of the detected specific phase.

A nuclear magnetic resonance sensing method according to the present invention includes a step of applying a high frequency magnetic field based on an RF signal to a target object and generating an observation signal having a frequency shifted from a frequency of the RF signal by a frequency of a nuclear magnetic resonance signal, a step of performing intermediate frequency demodulation of the observation signal based on a local oscillation signal to generate an intermediate frequency demodulation signal including the nuclear magnetic resonance signal, a step of attenuating a component of a high frequency band side of the intermediate frequency demodulation signal by a low-pass filter, a step of digitizing the intermediate frequency demodulation signal that has passed through the low-pass filter by a digitizing device, a step of generating a pseudo intermediate frequency signal from the local oscillation signal and the RF signal, and a step of detecting a specific phase in a waveform of the pseudo intermediate frequency signal. In the step of digitizing, (a) a magnetic field or an electric field corresponding to the intermediate frequency demodulation signal that has passed through the low-pass filter is generated, (b) light corresponding to the magnetic field or the electric field is generated by a sensing element, (c) the light is converted into an electrical signal as a sensor signal using a photoelectric element, and (d) the sensor signal is digitized by an analog/digital converter. Further, in the step of digitizing, the sensing element is caused to generate the light corresponding to the magnetic field or the electric field by performing a quantum operation on the sensing element at a timing of the detected specific phase.

### EFFECTS OF THE INVENTION

According to the present invention, it is possible to obtain a nuclear magnetic resonance sensing device and a nuclear magnetic resonance sensing method in which a timing, at which a quantum operation is performed, is appropriately set and sensing is performed with the excellent sensitivity.

### BRIEF DESCRIPTION OF THE DRAWINGS

[Fig. 1] Fig. 1 is a block diagram that shows a configuration of a nuclear magnetic resonance sensing device according to a first embodiment of the present invention.
[Fig. 2] Fig. 2 is a block diagram that shows a configuration of a digitizing device 21 shown in Fig. 1.
[Fig. 3] Fig. 3 is a diagram that shows a configuration of a sensor body 51 in the digitizing device according to the first embodiment.
[Fig. 4] Fig. 4 is a diagram that explains a specific phase in a pseudo IF signal.
[Fig. 5] Fig. 5 is a block diagram that shows a configuration of a nuclear magnetic resonance sensing device according to a second embodiment of the present invention.
[Fig. 6] Fig. 6 is a block diagram that shows a configuration of a nuclear magnetic resonance sensing device according to the second embodiment of the present invention.

### EMBODIMENTS FOR CARRYING OUT THE INVENTION

Embodiments of the present invention will be explained below with reference to the drawings.

### FIRST EMBODIMENT

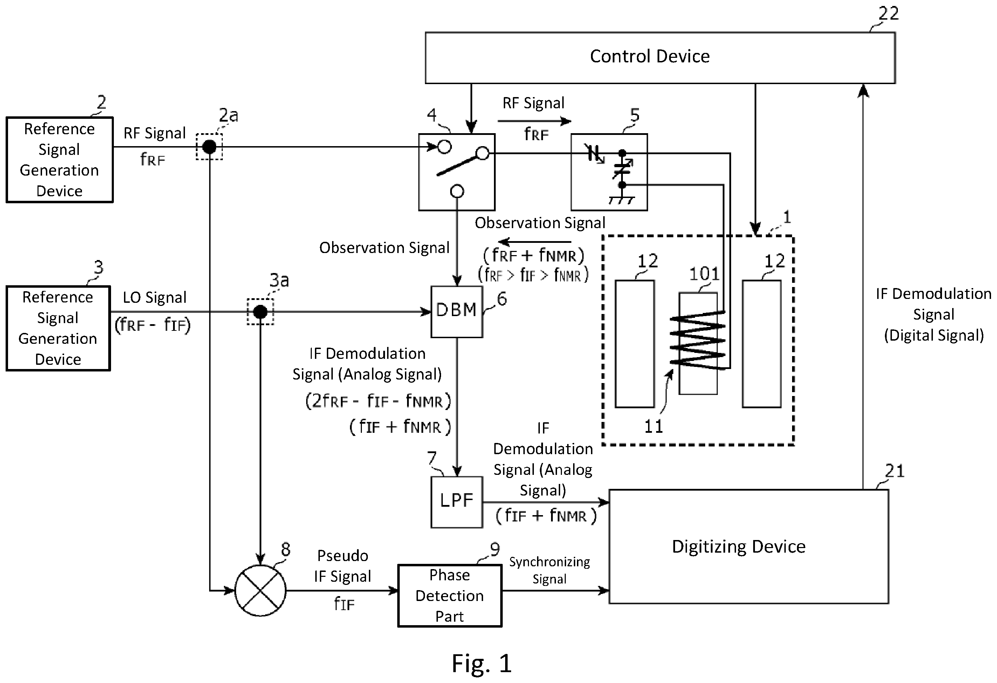

Fig. 1 is a block diagram that shows a configuration of a nuclear magnetic resonance sensing device according to a first embodiment of the present invention. The nuclear magnetic resonance sensing device is used for, for instance, a molecular structure analysis and imaging of a target object.

The nuclear magnetic resonance sensing device shown in Fig. 1 has a nuclear magnetic resonance sensing part 1, reference signal generation devices 2 and 3, a switching part 4, a matching/tuning circuit 5, a mixer part 6, and a low-pass filter 7.

The nuclear magnetic resonance sensing part 1 applies an RF signal described below to a target object and generates an observation signal (an analog electrical signal) with a frequency (f_{RF} + f_{NMR}) that is shifted from a frequency f_{RF} of the RF signal by a frequency f_{NMR} of a nuclear magnetic resonance (NMR) signal.

Specifically, the nuclear magnetic resonance sensing part 1 has a coil 11 and a magnet part 12. The coil 11 applies a high frequency magnetic field based on the RF signal to the target object 101, senses a magnetic field change based on movement (motion) of nuclear magnetization in the target object 101, and outputs an observation signal. The magnet part 12 is a permanent magnet or an electromagnet and applies a static magnetic field or a gradient magnetic field to the target object 101. This observation signal includes the NMR signal and has the frequency (f_{RF} + f_{NMR}) that is the sum of the frequency f_{NMR} and the RF signal frequency f_{RF}.

The reference signal generation device 2 generates and outputs the RF signal. The reference signal generation device 3 generates and outputs a local oscillation (LO) signal. The LO signal has a frequency that is lower than the RF signal frequency f_{RF} by a single intermediate frequency f_{IF}. The RF signal is branched at a coupler 2a. Further, the LO signal is branched at a splitter 3a so that the branched signals have the same level each other after the splitting.

The switching part 4 switches a connection destination for a side of the nuclear magnetic resonance sensing part 1 (the nuclear magnetic resonance sensing part via the matching/tuning circuit 5) from one of a transmission system of the RF signal (the reference signal generation device 2) and a reception system of the observation signal (the reference signal generation devices 2 and 3, the mixer part 6, and the low-pass filter 7) to the other. Specifically, when transmitting the RF signal, the switching part 4 electrically connects the transmission system to the side of the nuclear magnetic resonance sensing part 1, and when receiving the observation signal, the switching part 4 electrically connects the reception system to the side of the nuclear magnetic resonance sensing part 1.

The matching/tuning circuit 5 is a circuit that performs an impedance matching so as to suppress a reflection of the RF signal at the nuclear magnetic resonance sensing part 1, and at the same time, performs a frequency tuning so as to improve a level of the NMR signal.

The mixer part 6 performs intermediate frequency demodulation of the observation signal based on the LO signal and generates an intermediate frequency demodulation signal (an IF demodulation signal) including the nuclear magnetic resonance signal. Specifically, the mixer part 6 mixes the observation signal and the LO signal, performs the intermediate frequency (IF) demodulation, and generates and outputs the IF demodulation signal having two frequency components of (2f_{RF} - f_{IF} - f_{NMR}) and (f_{IF} + F_{NMR}). For instance, the mixer part 6 is a DBM (Double Balanced Mixer) that is configured with a diode and a phase distributor and does not include an active element such as a transistor.

The low-pass filter 7 attenuates a component of a high frequency band side (2f_{RF} - f_{IF} - f_{NMR}) among two band components, (2f_{RF} - f_{IF} - f_{NMR}) and (fIF + f_{NMR}), that are obtained by the IF demodulation by the mixer part 6, of the above-mentioned IF demodulation signal and is a filter that passes a component of a low frequency band side (f_{IF} + f_{NMR}) among the two band components. Further, the low-pass filter 7 is an analog filter that is configured with only a passive element, such as a capacitor, an inductor, or a resistor.

Further, the nuclear magnetic resonance sensing device shown in Fig. 1 has a mixer part 8 and a phase detection part 9.

The mixer part 8 generates a pseudo intermediate frequency signal (a pseudo IF signal with a frequency f_{IF}) from the LO signal and the RF signal. Here, in order to suppress the delay between the IF demodulation signal and the pseudo IF signal, it is preferred that the mixer part 8 can use the same mixer part as the mixer part 6.

The phase detection part 9 detects a specific phase in a waveform of the pseudo IF signal, and generates and outputs a synchronizing signal indicating the specific phase. The phase detection part 9 may detect the specific phase using a comparator (such as a zero-cross comparator) . Alternatively, the phase detection part 9 may convert the pseudo IF signal into a digital signal using an analog/digital converter and then perform signal processing on the digital signal using such as a DSP (Digital Signal Processor) so as to detect the specific phase.

Further, the nuclear magnetic resonance sensing device shown in Fig. 1 has a digitizing device 21 and a control device 22.

The digitizing device 21 converts the IF demodulation signal (the frequency component (f_{IF} + f_{NMR})) that is output from the low-pass filter 7 from an analog signal to a digital signal.

The control device 22 has a computer that operates according to a control program. The computer has such as a CPU (Central Processing Unit), a ROM (Read Only Memory), and a RAM (Random Access Memory) and performs operations (processes) described below by loading the control program into the RAM and executing it via the CPU. Specifically, the control device 22 controls the nuclear magnetic resonance sensing part 1 and the switching part 4 so that the nuclear magnetic resonance sensing part 1 is applied with the above-mentioned high frequency magnetic field and outputs the above-mentioned observation signal. Furthermore, the control device 22 receives the IF demodulation signal (frequency component (f_{IF} + f_{NMR})) as a digital signal from the digitizing device 21 and performs a predetermined signal processing (for instance, an extraction of the frequency component f_{NMR}) so that the frequency f_{NMR} component (that is, the NMR signal) is extracted from the IF demodulation signal (the frequency component (f_{IF} + f_{NMR})).

For example, f_{IF} is a frequency that is sufficiently higher than f_{NMR}. Further, f_{RF} is a frequency that is sufficiently higher than f_{IF}. For instance, when f_{NMR} = 1 kHz, f_{RF} = 43 MHz, and f_{IF} = 30 kHz (or f_{IF} = 100 kHz) .

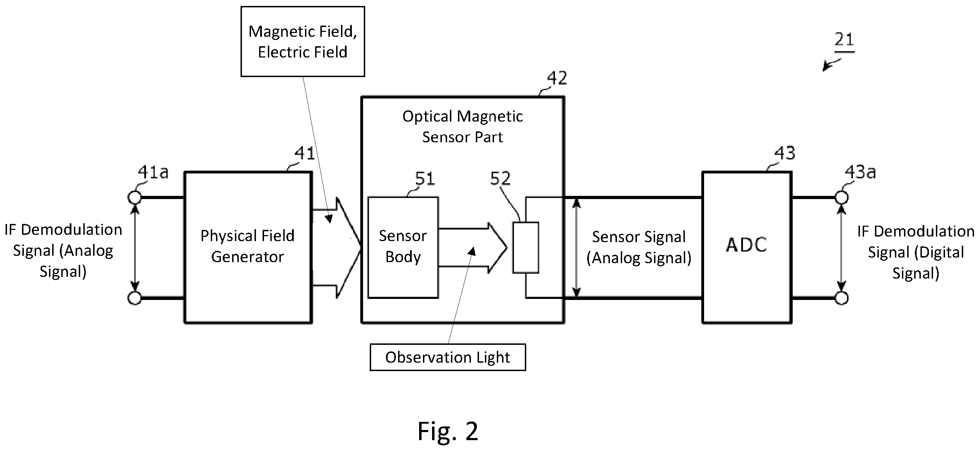

Fig. 2 is a block diagram that shows a configuration of a digitizing device 21 shown in Fig. 1. The digitizing device shown in Fig. 1 has a physical field generator 41, an optical quantum sensor part 42, and an analog/digital converter (A/D converter, ADC) 43.

The physical field generator 41 generates a magnetic field corresponding to an input signal (that is, an analog IF demodulation signal that has passed through the low-pass filter 7) that is input via an input terminal 41a of the physical field generator 41. For instance, the physical field generator 41 generates the magnetic field using a conductive coil or wiring.

The optical quantum sensor part 42 has a sensor body 51 and a photoelectric element 52. In the sensor body 51, a sensing member generates light (observation light) corresponding to the magnetic field that is generated by the physical field generator 41 and the photoelectric element 52 converts the light into an electrical signal as a sensor signal. The photoelectric element 52 is, for instance, a photodiode or a phototransistor and generates the sensor signal corresponding to intensity of the entered observation light.

Specifically, the optical quantum sensor part 42 (specifically, the sensor body 51) performs a quantum operation (here, a quantum operation by a microwave and a laser beam) on the sensing member at a timing of the specific phase specified by the synchronizing signal, so that the sensing member generates the light corresponding to the magnetic field that is generated by the physical field generator 41.

In the first embodiment, the optical quantum sensor part 42 (specifically, the sensor body 51) performs the quantum operation on the sensing member according to an optically detected magnetic resonance measurement method (ODMR) so that the sensing member generates the above-mentioned observation light.

Note that it is preferred that the phase detection part 9 detects a specific phase in the waveform of the pseudo IF signal immediately after the start of free induction decay. Further, it is preferred that the optical quantum sensor part 42 applies a microwave to the sensing member 1 at the timing of the specific phase, thereby performing the above-mentioned quantum operation on the sensing member 1.

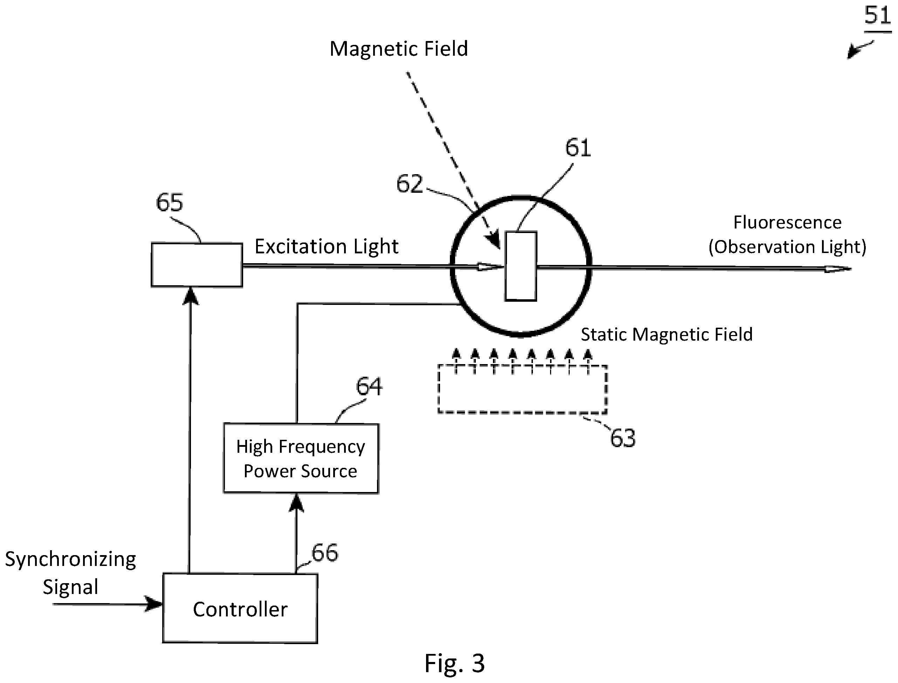

Fig. 3 is a diagram that shows a configuration of a sensor body 51 in the digitizing device according to the first embodiment. In the first embodiment, for the ODMR, as shown in, for instance, Fig. 3, the sensor body 51 has a magnetic resonance member 61, a high frequency magnetic field generator 62, and a magnet 63 as the sensing member, a high frequency power source 64, a light emitting device 65, and a controller 66.

The magnetic resonance member 61 has a crystal structure. The electron spin quantum state changes in correspond with the magnetic field that is generated by the physical field generator 41, and at the same time, the magnetic resonance member 61 is a member capable of an electron spin quantum operation by a microwave (based on Rabi vibration) at a frequency that corresponds to a defect in a crystal lattice and an arrangement direction of impurities. That is, the magnetic resonance member 61 is placed within the above-mentioned magnetic field.

In this embodiment, the magnetic resonance member 61 is an optically detected magnetic resonance member having a plurality (that is, an ensemble) of specific color centers. This specific color center has an energy level capable of Zeeman splitting, and at the same time, can take a plurality of directions in which shift widths of the energy level at the time of Zeeman splitting are different from each other.

Here, the magnetic resonance member 61 is a member such as a diamond that includes a plurality of NV (Nitrogen Vacancy) centers as a specific color center of a single category (or type). In the case of the NV center, a ground state is a triplet state of ms = 0, +1, -1 and a level of ms = +1 and a level of ms = -1 undergo Zeeman splitting. When the NV center transitions from an excited state at the levels of ms = +1 and ms = -1 to the ground state, the NV center is accompanied by fluorescence at a predetermined proportion and the remaining proportion of the NV center transitions from the excited state (ms = +1 or ms = -1) to the ground state (ms = 0) with non-radiation. Note that the color center included in the magnetic resonance member 61 may be a color center other than the NV center.

The high frequency magnetic field generator 62 applies a microwave to the magnetic resonance member 61 so as to perform an electron spin quantum operation of the magnetic resonance member 61. For instance, the high frequency magnetic field generator 62 is a plate-shaped coil and has a substantially circular coil part that emits the microwave and terminal parts that extend from both ends of the coil part and are fixed to a substrate. The high frequency power source 64 generates a current of the microwave and is conductively connected to the high frequency magnetic field generator 62. The coil part conducts two currents that are mutually in parallel at a predetermined interval so as to sandwich the magnetic resonance member 61 at both end surface parts of the coil part and emit the above-mentioned microwave. Here, the coil part is the plate-shaped coil, however, because the current of the microwave flows through the end surface part of the coil part due to a skin effect, two currents are formed. As a result, the microwave with a substantially uniform intensity is applied to the magnetic resonance member 61.

In the case of the NV center, since the color center is formed by a defect (vacancy) (V) and nitrogen (N) as an impurity in the diamond crystal, there are four possible positions for adjacent nitrogen (N) with respect to the defect (vacancy) (V) in the diamond crystal (that is, the arrangement directions of a pair of the vacancy and the nitrogen). Sub-levels (that is, the energy levels from the ground) after Zeeman splitting respectively corresponding to these arrangement directions are different from each other. Therefore, in a characteristic of a fluorescence intensity after Zeeman splitting due to a static magnetic field with respect to a frequency of the microwave, in correspond with each direction i (i = 1, 2, 3, 4), four pairs of dip frequencies (fi+, fi-) that are different from one another appear. Here, the above-mentioned frequency of the microwave (wavelength) is set in correspond with any of the dip frequencies of these four pairs of dip frequencies.

Further, the magnet 63 applies a static magnetic field (a DC magnetic field) to the magnetic resonance member 61 so that the energy levels of a plurality of specific color centers (here, a plurality of NV centers) in the magnetic resonance member 61 undergo Zeeman splitting. Here, the magnet 63 is a ring-type permanent magnet, such as a ferrite magnet, an alnico magnet, or a samarium cobalt magnet. Further, the magnet 63 may be an electromagnet.

Further, in the magnetic resonance member 61, as the arrangement direction of the above-mentioned defect and impurity is substantially coincident with the above-mentioned direction of the static magnetic field (and the direction of the applied magnetic field), the crystal of the magnetic resonance member 61 is formed and the direction of the magnetic resonance member 61 is set.

Furthermore, in this embodiment, in order to irradiate the magnetic resonance member 41 with excitation light, an optical system (not shown) from the light emitting device 65 to the magnetic resonance member 61 is provided. Further, in order to detect fluorescence (the observation light) from the magnetic resonance member 61, an optical system (not shown) from the magnetic resonance member 61 to the photoelectric element 52 is provided.

The observation light is concentrated toward the photoelectric element 52 by an optical system such as a compound parabolic concentrator (CPC). For instance, the magnetic resonance member 61 is arranged on the CPC, and among the fluorescence that is emitted in all directions from a color center in the magnetic resonance member 61, the fluorescent that is emitted in a wide solid angle (for instance, more than a predetermined percentage of all directions) by this optical system is concentrated.

The light emitting device 65 has such as a laser diode as a light source and the light source emits a laser beam (laser light) of a predetermined wavelength as excitation light to be irradiated to the magnetic resonance member 61.

According to a predetermined measurement sequence (for instance, a Hahn echo sequence), the controller 66 (a) controls the high frequency power source 64 and the light emitting device 65, performs a quantum operation using the microwave and the laser light mentioned above, causes the sensor body 51 to generate the observation light, and causes the photoelectric element 52 to generate the sensor signal. For instance, the controller 66 has a computer that operates according to a control program. The computer has a CPU, a ROM, a RAM (Random Access Memory), etc., and performs the above-mentioned operations (or processes) by loading the control program into the RAM and executing it on the CPU. Further, the controller 66 may be built into the control device 22 or the control device 22 may operate as the controller 66.

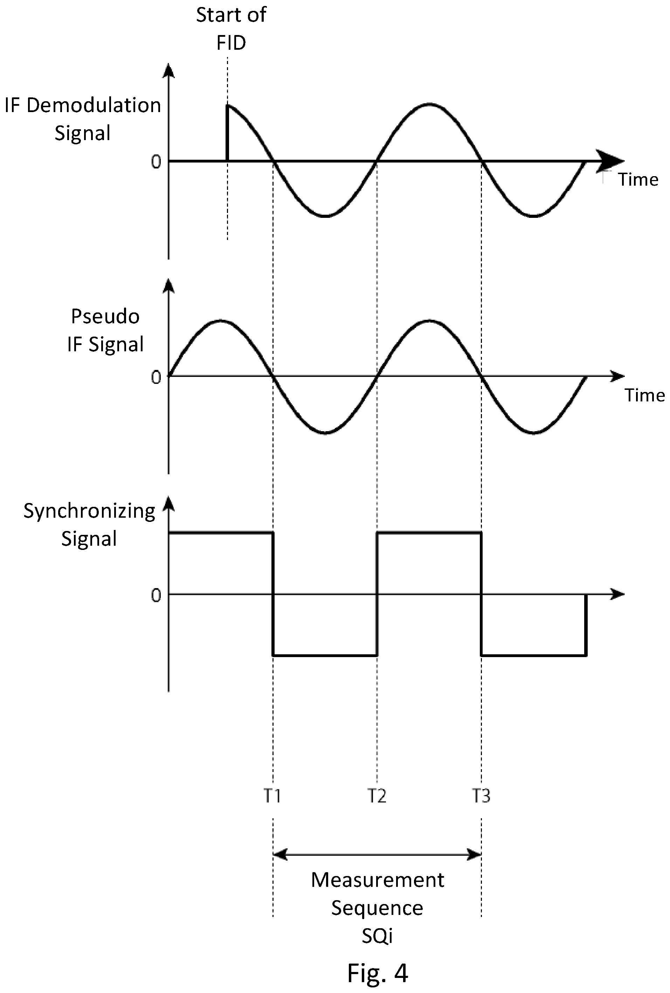

Fig. 4 is a diagram that explains a specific phase in a pseudo IF signal. In this embodiment, as shown in, for instance, Fig. 4, the phase detection part 9 detects consecutive specific phases, 0 degrees, 180 degrees, and 360 degrees, in the waveform of the pseudo IF signal. The optical quantum sensor part 42 applies a microwave to the sensing member 1 at timings T1, T2, and T3 of the detected specific phases according to the Hahn echo sequence, thereby performing the above-mentioned quantum operation on the sensing member 1. According to the Hahn echo sequence, the microwave with a π/2 pulse is applied at the timings T1 and T3, and the microwave with a π pulse is applied at the timing T2.

Note that there is a difference (= f_{NMR}) between the frequency f_{IF} of the pseudo IF signal and the frequency (f_{IF} + f_{NMR}) of the IF demodulation signal. However, as shown in, for instance, Fig. 4, since f_{NMR} is sufficiently small compared to f_{IF}, the pseudo IF signal is substantially synchronized with the IF demodulation signal (especially at the beginning of observation). Therefore, based on the above-mentioned synchronizing signal, the above-mentioned quantum operation is performed at an appropriate timing in the IF demodulation signal.

Note that the measurement sequence is not limited to the Hahn echo sequence. The measurement sequence may be selected according to the frequency of the magnetic field of the measurement target. For instance, when the period of the above-mentioned magnetic field is equal to or longer than a T2 relaxation time, the magnetic field measurements are performed the plurality of times with Ramsey pulse sequences as mentioned above. When the period of the above-mentioned magnetic field is shorter than the T2 relaxation time, the spin echo pulse sequence (for instance, Hahn echo sequence) may be applied. Furthermore, when the period of the above-mentioned magnetic field is shorter than 1/2 of the T2 relaxation time, the magnetic field measurement may be performed according to a Qdyne method.

Refer back to Fig. 2, the A/D converter 43 digitizes the above-mentioned sensor signal (without digitizing the input signal). As a result, the A/D converter 43 generates a digital signal as an output signal corresponding to the input signal (IF demodulation signal) and outputs it via an output terminal 43a of the A/D converter 43.

In this embodiment, in particular, the optical quantum sensor part 42 (specifically, the sensor body 51) causes the sensing member (the magnetic resonance member 61) to generate the above-mentioned observation light in a state in which the level of the sensor signal exceeds the noise floor of the A/D converter 43.

Here, the level (amplitude) of the sensor signal changes according to a factor, such as the efficiency of the sensing member (in the first embodiment, for instance, the type or the number of the color centers in the magnetic resonance member 61), the light concentration efficiency of the observation light (in the first embodiment, the amount of the entered light to the photoelectric element 52 relative to the light emission amount of the color center), or the conversion efficiency of the photoelectric element 52 (the level of the sensor signal relative to the amount of the entered light). Therefore, according to the noise floor (already known) of the A/D converter 43, the value(s) of the factor(s) is determined so that the level of the sensor signal exceeds the noise floor of the A/D converter 43. As a result, for instance, the sensitivity of the optical quantum sensor part 42 is set to 1.5 pT / Hz^{1/2} or more.

Further, in general, the noise of an A/D converter includes quantization noise and thermal noise, and in a high-resolution A/D converter, the thermal noise is more dominant than the quantization noise. The A/D converter 43 in this embodiment is a high-resolution A/D converter and the value(s) of the above-mentioned factor(s) is determined so that the level of the sensor signal exceeds the noise level of the thermal noise.

Further, a reference voltage of the A/D converter 43 is set according to a range (a minimum level value and a maximum level value) of the sensor signal. Further, by lowering the reference voltage of the A/D converter, the quantization noise is reduced, however, the thermal noise is not reduced.

Note that a level (or a range) of the IF demodulation signal being input and electromagnetic conversion efficiency of the physical field generator 41 are already known.

Furthermore, in this embodiment, in particular, the digitizing device 21 does not have an amplifier circuit, in which the sensor signal is electrically amplified, between the photoelectric element 52 and the A/D converter 43. Furthermore, in this embodiment, an amplifier circuit, in which the input signal is electrically amplified, is not provided between a signal source of the input signal and the physical field generator 41. That is, in this embodiment, an electrical amplifier circuit that is a noise source is not provided at an upstream side of the A/D converter 43. Because the thermal noise is generated and amplified in such the amplifier circuit in the same way as the A/D converter 43, the noise is superposed on a signal that is input to the A/D converter 43. Therefore, it is preferred that an amplifier circuit is not provided as mentioned above.

Further, the high frequency power source 64 and the controller 66 are electrically separated from the A/D converter 43 so as to prevent the electrical noise that is generated by the high frequency power source 64 and the controller 66 from invading (inputting) into the A/D converter 43.

Furthermore, in this first embodiment, the optical quantum sensor part 42 (the controller 66) repeatedly and periodically performs a quantum operation with respect to the sensing member according to the synchronizing signal so that the light corresponding to the magnetic field is generated by the sensing member. As a result, the digitizing device 21 outputs a digital IF demodulation signal in synchronization with the synchronizing signal. Thus, the control device 22 accurately identifies the frequency f_{NMR} of the NMR signal based on this digital IF demodulation signal according to the Qdyne method.

Further, in this first embodiment, neither an amplifier circuit nor a buffer is provided between the nuclear magnetic resonance sensing part 1 and the digitizing device 21. That is, since only a passive element is used in a circuit from the nuclear magnetic resonance sensing part 1 to the digitizing device 21, the generation of the thermal noise is suppressed.

Next, operations of the nuclear magnetic resonance sensing device according to the first embodiment will be explained.

The control device 22 controls the nuclear magnetic resonance sensing part 1, and at the same time, controls the switching part 4. The control device 22 applies a high frequency magnetic field based on the RF signal from the transmission system to the target object 101 in the nuclear magnetic resonance sensing part 1. The control device 22 controls the switching part 4 so as to conduct the observation signal from the nuclear magnetic resonance sensing part 1 to the reception system.

As shown in Fig. 1, the observation signal is converted into the IF demodulation signal based on the LO signal by the mixer part 6. Further, the IF demodulation signal from which the component on the side of the high frequency band is removed by the low-pass filter 7 is input to the digitizing device 21.

Furthermore, the mixer part 8 generates the pseudo IF signal from the RF signal and the LO signal. Further, the phase detection part 9 generates the synchronizing signal indicating the specific phase from the pseudo IF signal.

In the digitizing device 21, when the IF demodulation signal is applied to the physical field generator 41, a magnetic field with an intensity corresponding to the level of the input signal is generated in the physical field generator 41 and is applied to the sensor body 51 of the optical quantum sensor part 42.

In the sensor body 51, the measurement sequence is executed in synchronization with the synchronizing signal as mentioned above, and the light having a light quantity corresponding to the strength of the magnetic field is generated. In the first embodiment, according to the ODMR, the magnetic resonance member 61 generates the light having the light quantity corresponding to the strength of the magnetic field.

Thereafter, the photoelectric element 52 receives the light, generates the sensor signal having the level corresponding to the light quantity of the received light, and outputs the sensor signal to the A/D converter 43.

The A/D converter 43 digitizes the sensor signal, generates the digital IF demodulation signal corresponding to the analog IF demodulation signal, and outputs the digital IF demodulation signal to the control device 22.

The control device 22 continuously and repeatedly acquires the value of the digital IF demodulation signal, derives the NMR signal (specifically, for instance, f_{NMR}) by the signal processing as mentioned above, and performs such as the molecular structure analysis or the imaging of the target object 101 based on the NMR signal.

As mentioned above, according to the first embodiment, the nuclear magnetic resonance sensing part 1 applies the high frequency magnetic field based on the RF signal to the target object, and generates the observation signal having the frequency shifted from the frequency of the RF signal by the frequency of the NMR signal. The mixer part 6 generates the IF demodulation signal including the NMR signal based on the LO signal. The low-pass filter 7 attenuates the component of the high frequency band side of the IF demodulation signal. On the other hand, the mixer part 8 generates the pseudo IF signal from the LO signal and the RF signal. Further, the phase detection part 9 detects the specific phase in the waveform of the pseudo IF signal. In the digitizing device 21, the physical field generator 41 generates such as the magnetic field corresponding to the IF demodulation signal that has been passed through the low-pass filter 7. The optical quantum sensor part 42 causes the sensing member to generate the light corresponding to such as the magnetic field. The photoelectric element converts the light into the sensor signal. Further, the analog/digital converter 43 digitizes the sensor signal. This optical quantum sensor part 42 performs the quantum operation with respect to the sensing member at the timing of the detected specific phase and causes the sensing member to generate the light corresponding to the above-mentioned magnetic field or the above-mentioned electric field.

As a result, the quantum operation is performed in synchronization with the pseudo IF signal, which is substantially synchronization with the IF demodulation signal. Therefore, the timing for performing the quantum operation is set appropriately and the nuclear magnetic resonance sensing is performed with the excellent sensitivity.

### SECOND EMBODIMENT

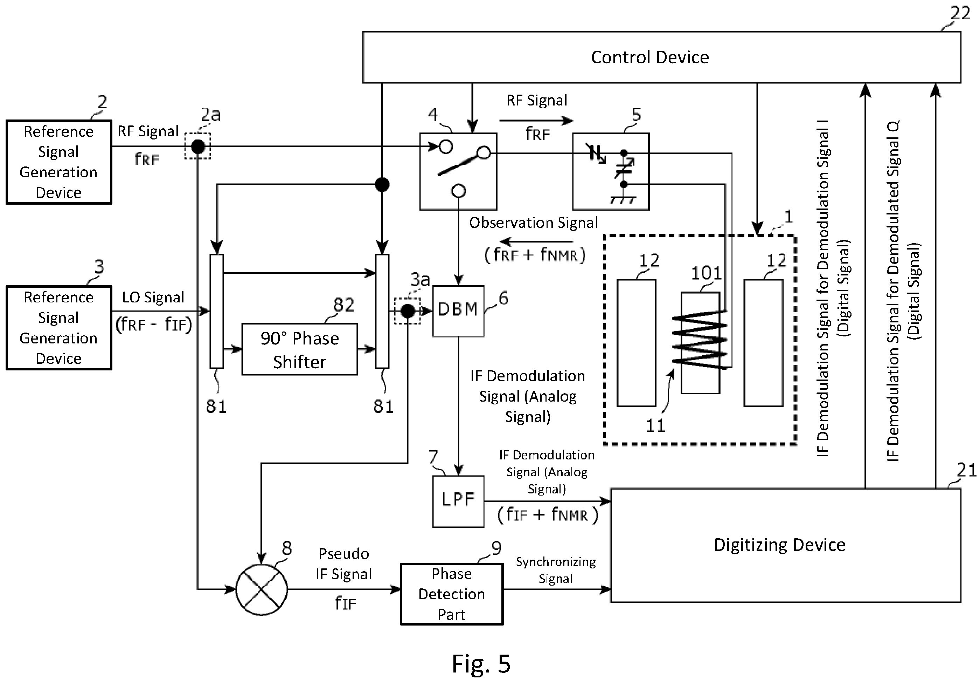

Fig. 5 is a block diagram that shows a configuration of a nuclear magnetic resonance sensing device according to a second embodiment of the present invention. As shown in Fig. 5, the nuclear magnetic resonance sensing device according to the second embodiment further has a switching part 81 and a 90-degree phase shifter 82.

The 90-degree phase shifter 82 performs a 90-degree phase shift with respect to the LO signal at the intermediate frequency fIF. The switching part 81 is controlled by the control device 22 and switches between inputting the LO signal to the 90-degree phase shifter 82 and outputting the LO signal, in which the 90-degree phase shift is (has been) performed, to the mixer parts 6 and 8 and bypassing the 90-degree phase shifter 82 and outputting the LO signal (the LO signal that has not been phase-shifted by 90 degrees) to the mixer parts 6 and 8. For instance, the control device 22 causes the switching part 81 to alternately output the LO signal and the LO signal, in which the 90-degree phase shift is (has been) performed, for each of the above-mentioned measurement sequence in the digitizing device 21.

Therefore, the mixer part 6 (a) generates the IF demodulation signal based on the LO signal, and at the same time, (b) generates the IF demodulation signal based on the LO oscillation signal in which the 90-degree phase shift is (has been) performed. Further, the mixer part 8 (a) generates the pseudo IF signal from the LO signal and the RF signal, and at the same time, (b) generates the pseudo IF signal, in which the 90-degree phase shift is (has been) performed, from the LO signal, in which the 90-degree phase shift is (has been) performed, and the RF signal.

In addition, the digitizing device 21 (a) digitizes the IF demodulation signal and outputs it to the control device 22, and at the same time, (b) digitizes the IF demodulation signal, in which the 90-degree phase shift is (has been) performed, and outputs it to the control device 22. In the control device 22, a quadrature (orthogonal) phase detection demodulation signal I is generated based on the digitized IF demodulation signal, and a quadrature (orthogonal) phase detection demodulated signal Q is generated based on the digitized IF demodulation signal in which the 90-degree phase shift is (has been) performed.

In the second embodiment, the control device 22 demodulates the digitized IF demodulation signal and the digitized IF demodulation signal, in which the 90-degree phase shift is (has been) performed, so as to generate the demodulation signal I and the demodulated signal Q (frequency component f_{NMR}), respectively, and perform predetermined signal processing so as to extract the NMR signal (frequency component f_{NMR}). Further, in this predetermined signal processing, a Fourier transform such as a FFT (Fast Fourier Transform) is performed with respect to each of the demodulation signal I and the demodulated signal Q, and the frequency components of the demodulation signal I and the demodulated signal Q are respectively identified. As a result, for instance, the NMR signal (frequency component f_{NMR}) is extracted, and a chemical shift is detected.

Note that the other configurations and operations of the nuclear magnetic resonance sensing device according to the second embodiment are the same as those explained in the first embodiment. Therefore, the explanations of the other configurations and operations of the nuclear magnetic resonance sensing device according to the second embodiment will be omitted.

### THIRD EMBODIMENT

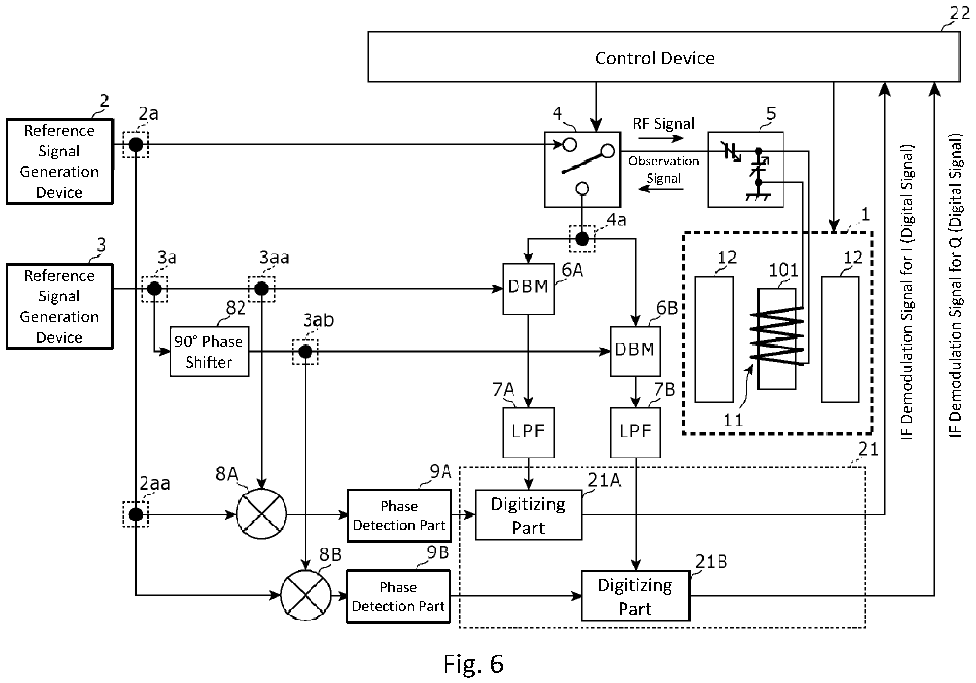

Fig. 6 is a block diagram that shows a configuration of a nuclear magnetic resonance sensing device according to a third embodiment of the present invention. As shown in Fig. 6, the nuclear magnetic resonance sensing device according to the third embodiment has mixer parts 6A and 6B similar to (that are the same as) the mixer part 6, low-pass filters 7A and 7B similar to (that are the same as) the low-pass filter 7, mixer parts 8A and 8B similar to (that are the same as) the mixer part 8, and phase detectors 9A and 9B similar to (that are the same as) the phase detector 9. In addition, the digitizing device 21 in the third embodiment has digitizing parts 21A and 21B similar to (that are the same as) the digitizing device 21 in the first embodiment or the second embodiment. That is, in the third embodiment, two measurement systems are provided to respectively obtain the demodulation signal I and the demodulated signal Q by the quadrature (orthogonal) phase detection.

Furthermore, in the third embodiment, as shown in Fig. 6, branching parts 2a, 2aa, 3a, 3aa, 3ab, and 4a such as couplers and splitters are provided. Further, the RF signals branched by the branching parts 2a and 2aa are respectively input to the mixer parts 8A and 8B. In addition, the LO signal branched by the branching part 3a is input to the 90-degree phase shifter 82. The LO signal branched by the branching part 3aa is input to the mixer part 8A. The LO signal, in which the 90-degree phase shift is (has been) performed, branched by the branching part 3ab is input to the mixer part 8B. Furthermore, the observation signals branched by the branching part 4a are input to the mixer parts 6A and 6B.

The phase detection parts 9A and 9B respectively detect specific phases in the waveforms of the pseudo IF signals from the mixer parts 8A and 8B, and generate and output synchronizing signals indicating the specific phases.

On the other hand, the mixer part 6A performs intermediate frequency demodulation of the observation signal based on the LO signal and generates an intermediate frequency demodulation signal (the IF demodulation signal) including the nuclear magnetic resonance signal. Further, the mixer part 6B performs the intermediate frequency demodulation of the observation signal based on the LO signal, in which the 90-degree phase shift is (has been) performed, and generates an intermediate frequency demodulation signal (the IF demodulation signal) including the nuclear magnetic resonance signal.

For each of the IF demodulation signals from the mixer parts 6A and 6B, the low-pass filters 7A and 7B attenuate the component of the high frequency band side (2f_{RF} - f_{IF} - f_{NMR}) among the two band components, (2f_{RF} - f_{IF} - f_{NMR}) and (fIF + f_{NMR}) , that are obtained by the IF demodulation by the mixer parts 6A and 6B, and pass the component of the low frequency band side (f_{IF} + f_{NMR}) among the two band components. The IF demodulation signals that have passed through the low-pass filters 7A and 7B are input to the digitizing parts 21A and 21B, respectively.

In the same way as the digitizing device 21 in the first embodiment, the digitizing part 21A uses the synchronizing signal from the phase detection part 9A to convert the IF demodulation signal output from the low-pass filter 7A from an analog signal to a digital signal, and outputs this digital signal to the control device 22 as the IF demodulation signal for the quadrature (orthogonal) detection demodulation signal I. In addition, in the same way as the digitizing device 21 in the first embodiment, the digitizing part 21B uses the synchronizing signal from the phase detection part 9B to convert the IF demodulation signal output from the low-pass filter 7B from an analog signal to a digital signal, and outputs this digital signal to the control device 22 as the IF demodulation signal for the quadrature (orthogonal) detection demodulated signal Q.

Further, in the third embodiment, the control device 22 demodulates the digitized IF demodulation signal and the digitized IF demodulation signal, in which the 90-degree phase shift is (has been) performed, obtained from the digitizing parts 21A and 21B so as to respectively generate the demodulation signal I and the demodulated signal Q (frequency component f_{NMR}) and perform the predetermined signal processing so as to extract the NMR signal (frequency component f_{NMR}). Further, in this predetermined signal processing, a Fourier transform such as a FFT (Fast Fourier Transform) is performed with respect to each of the demodulation signal I and the demodulated signal Q so that the frequency components of the demodulation signal I and the demodulated signal Q are identified. As a result, for instance, the NMR signal (frequency component f_{NMR}) is extracted, and a chemical shift is detected. In particular, in the third embodiment, the switching part 81 shown in the second embodiment is not provided, and the demodulation signal I and the demodulated signal Q are simultaneously acquired. As a result, the NMR signal in a wideband can be extracted in a short period of time.

Note that the other configurations and operations of the nuclear magnetic resonance sensing device according to the third embodiment are the same as those explained in the first embodiment or the second embodiment. Therefore, the explanations of the other configurations and operations of the nuclear magnetic resonance sensing device according to the third embodiment will be omitted.

Note that various changes and modifications to the embodiments described above will be apparent to one having ordinally skill in the art. Such the changes and modifications may be made without departing from the spirit and scope of the subject matter and without diminishing the intended advantages. That is, it is intended that such the changes and modifications are included within the scope of the claims.

For instance, in the first, second, and third embodiments, the measurement method in the sensor body 51 is not limited to the above-mentioned ODMR. As long as being a measurement method in which a quantum operation with respect to a sensing member is performed by using the sensing member according to a physical field and it is capable of detecting observation light according to the physical field strength, any other measurement methods may be used.

Further, in the first, second, and third embodiments, a predetermined arithmetic processing with respect to the output signals in the control device 22 may be performed so that the values (digital values) of the output signals of the digitizing device 21 coincident with the levels of the analog IF demodulation signals.

Furthermore, in the first, second, and third embodiments, as necessary, a low noise buffer (voltage amplification degree is equal to 1) that satisfies a noise level requirement may be provided between the low-pass filter 7 and the digitizing device 21.

Furthermore, the digitizing device 21 in the first and second embodiments and the digitizing parts 21A and 21B in the third embodiment may be the same as those described in International Patent Publication Number WO 2023/089883.

### INDUSTRIAL APPLICABILITY

The present invention can be applicable to, for instance, various measurements and imaging using nuclear magnetic resonance.

## Claims

1. A nuclear magnetic resonance sensing device comprising:
a nuclear magnetic resonance sensing part that applies a high frequency magnetic field based on an RF signal to a target object and generates an observation signal having a frequency shifted from a frequency of the RF signal by a frequency of a nuclear magnetic resonance signal;
a first mixer part that performs intermediate frequency demodulation of the observation signal based on a local oscillation signal to generate an intermediate frequency demodulation signal including the nuclear magnetic resonance signal;
a low-pass filter that attenuates a component of a high frequency band side of the intermediate frequency demodulation signal;
a digitizing device that digitizes the intermediate frequency demodulation signal that has passed through the low-pass filter;
a second mixer part that generates a pseudo intermediate frequency signal from the local oscillation signal and the RF signal; and
a phase detection part that detects a specific phase in a waveform of the pseudo intermediate frequency signal,
wherein the digitizing device includes a physical field generator that generates a magnetic field or an electric field corresponding to the intermediate frequency demodulation signal that has passed through the low-pass filter, an optical quantum sensor part that generates light corresponding to the magnetic field or the electric field using a sensing member and converts the light into an electrical signal as a sensor signal using a photoelectric element, and an analog/digital converter that digitizes the sensor signal, and
the optical quantum sensor part causes the sensing member to generate the light corresponding to the magnetic field or the electric field by performing a quantum operation on the sensing member at a timing of the detected specific phase.

2. The nuclear magnetic resonance sensing device according to claim 1,
wherein the optical quantum sensor part causes the sensing member to generate the light corresponding to the magnetic field or the electric field by performing the quantum operation on the sensing member at the timing of the detected specific phase according to an optically detected magnetic resonance measurement method.

3. The nuclear magnetic resonance sensing device according to claim 2,
wherein the phase detection part detects 0 degrees, 180 degrees, and 360 degrees as the specific phase in the waveform of the pseudo intermediate frequency signal, and
the optical quantum sensor part causes the sensing member to generate the light corresponding to the magnetic field or the electric field by performing the quantum operation on the sensing member due to application of a microwave to the sensing member at the timing of the detected specific phase in accordance with a Hahn echo sequence.

4. The nuclear magnetic resonance sensing device according to claim 1,
wherein the phase detection part detects the specific phase immediately after a start of free induction decay in the waveform of the pseudo intermediate frequency signal.

5. The nuclear magnetic resonance sensing device according to claim 1, further comprising:
a 90-degree phase shifter that performs a 90-degree phase shift on the local oscillation signal at an intermediate frequency,
wherein the first mixer part (a) generates the intermediate frequency demodulation signal based on the local oscillation signal, and (b) generates the intermediate frequency demodulation signal based on the local oscillation signal in which the 90-degree phase shift has been performed,
the second mixer part (a) generates the pseudo intermediate frequency signal from the local oscillation signal and the RF signal, and (b) generates the pseudo intermediate frequency signal in which the 90-degree phase shift has been performed from the local oscillation signal in which the 90-degree phase shift has been performed and the RF signal, and
the digitizing device (a) digitizes the intermediate frequency demodulation signal, and (b) digitizes the intermediate frequency demodulation signal in which the 90-degree phase shift has been performed.

6. A nuclear magnetic resonance sensing method comprising:
a step of applying a high frequency magnetic field based on an RF signal to a target object and generating an observation signal having a frequency shifted from a frequency of the RF signal by a frequency of a nuclear magnetic resonance signal;
a step of performing intermediate frequency demodulation of the observation signal based on a local oscillation signal to generate an intermediate frequency demodulation signal including the nuclear magnetic resonance signal;
a step of attenuating a component of a high frequency band side of the intermediate frequency demodulation signal by a low-pass filter;
a step of digitizing the intermediate frequency demodulation signal that has passed through the low-pass filter by a digitizing device;
a step of generating a pseudo intermediate frequency signal from the local oscillation signal and the RF signal; and
a step of detecting a specific phase in a waveform of the pseudo intermediate frequency signal,
wherein, in the step of digitizing, (a) a magnetic field or an electric field corresponding to the intermediate frequency demodulation signal that has passed through the low-pass filter is generated, (b) light corresponding to the magnetic field or the electric field is generated by a sensing element, (c) the light is converted into an electrical signal as a sensor signal using a photoelectric element, and (d) the sensor signal is digitized by an analog/digital converter, and
in the step of digitizing, the sensing element is caused to generate the light corresponding to the magnetic field or the electric field by performing a quantum operation on the sensing element at a timing of the detected specific phase.
